# EUROPEAN PATENT APPLICATION

(11) **EP 4 852 041 A1**
(43) Date of publication of application: **09.12.2026**
(21) Application number: 25791168.5
(22) Date of filing: 24.06.2025
(51) Int. Cl.: H01H 13/84, H03K 17/90

(54) **CENTER-BOTTOMING MAGNETIC SWITCH KEY**

(30) Priority: 28.06.2024 CN 202421508984 U
(71) Applicant: Huizhou Huannuo Electronic Technology Co., Ltd., Huizhou, Guangdong 516000 (CN)
(72) Inventor: TENG, Boris, Shenzhen, Guangdong 518000 (CN); GU, Yuexin, Hengyang, Hunan 421819 (CN)
(74) Representative: Diaz Nunez, Joaquin
(86) International application number: PCT/CN2025/102888
(87) International publication number: WO 2026/001916

(57) **Abstract**

The present application discloses a central touch-bottom magnetic shaft key, and relates to the field of input devices. The key includes a body, a resettable key stem movably mounted within the body, a magnetic column arranged within the key stem, and a Hall sensing device located on one side of a bottom surface of the body and aligned with the magnetic column, where a bottom end of the key stem is a sealed solid bottom and cooperates with a bottom of the body, and the bottom end of the key stem contacts and collides with the bottom of the body in a case where the key is operated, so as to provide key feedback sound; the key stem includes a main component located at a top and a detachable component located at a bottom, at least the detachable component is a non-magnetic plastic part, and the main component and the detachable component are axially inserted and connected; a lower end of the detachable component is a solid bottom, and an upper end of the detachable component is provided with a mounting groove directed downward; and the magnetic column is inserted from a top end of the key body and fixed within the mounting groove. According to this key, a magnetic column is inserted from an upper part of a key stem, making a lower end of the key stem sealed as a solid bottom, and the sound produced during key operations is clearer and more focused, resulting in a more pleasant auditory feedback, which significantly enhances the user experience.

## Description

### TECHNICAL FIELD

The present application relates to the field of input devices, and in particular, to a central touch-bottom magnetic shaft key.

### BACKGROUND

In the prior art, a magnetic shaft key is typically designed as a structure where a magnetic column is mounted from a bottom of a key stem. This structure requires a hole to be formed at the bottom of the key stem to allow the magnetic column to be inserted from the bottom upwards into the key stem. Despite achieving the basic function of the magnetic shaft key, this structure presents several significant drawbacks in practical applications.

For mechanical keys, sound feedback is an important parameter that directly affects the use experience and purchasing decisions of the consumers.

Traditional magnetic shaft keys, due to the hole at the bottom of the key stem, often produce sound that is scattered and noisy during operation, with low sound focus. According to the position of the magnet within the slot, conventional magnetic shaft key designs can be categorized into three main types: core column peripheral bottoming, magnet bottoming, and side bottoming of the key stem.

According to the design of core column peripheral bottoming, the center of the key is hollow, which leads to a sound that is not concentrated or clear during key operations. The magnet bottoming design results in a harsh sound, making the auditory feedback less pleasant. According to the design of the side bottoming of the key stem, the collision at two sides of the key leads to sound that is similarly scattered and noisy. None of these three designs produces a sound as pleasant and satisfying as the sound generated by plastic colliding with plastic.

### SUMMARY

To overcome at least one defect in the prior art, the present application provides a central touch-bottom magnetic shaft key. According to this key, a magnetic column is inserted from an upper part of a key stem, making a lower end of the key stem sealed as a solid bottom, and the sound produced during key operation is clearer and more focused, resulting in a more pleasant auditory feedback, which significantly enhances the user experience.

To achieve the foregoing objective, the present application discloses a central touch-bottom magnetic shaft key, which includes a body, a resettable key stem movably mounted within the body, a magnetic column arranged within the key stem, and a Hall sensing device located on one side of a bottom surface of the body and aligned with the magnetic column, where a bottom end of the key stem is a sealed solid bottom and cooperates with a bottom of the body, and the bottom end of the key stem contacts and collides with the bottom of the body in a case where the key is operated, so as to provide key feedback sound.

Further, the key stem includes a main component located at a top and a detachable component located at a bottom, and the main component and the detachable component are axially inserted and connected; a lower end of the detachable component is a solid bottom, and an upper end of the detachable component is provided with a mounting groove directed downward, and a bottom of the mounting groove is positioned near a solid bottom end of the key body; and the magnetic column is inserted from a top end of the key body and fixed within the mounting groove.

Furthermore, a top end of the main component is provided with a clamping position for mounting a keycap.

Furthermore, a lower section of the detachable component is cylindrical.

Furthermore, a bottom end of the detachable component is provided with a plastic impact block.

Further, the body is provided with a vertical linear guide groove, and correspondingly, a guide block cooperating with the linear guide groove is laterally protruded on the main component of the key stem; and the cooperation between the linear guide groove and the guide block enables guidance during a vertical movement of the key stem.

Further, the body is composed of a base and a cover, the body is hollow to form a chamber for receiving and mounting the key stem, an upper end of the chamber is open, and the key stem extends through the opening.

Further, the key stem is connected and cooperates with the base via at least one elastic element, and the key stem resets after moving downward through the elastic element.

Furthermore, the elastic element is a coil spring.

Further, the body is mounted on a front side of a PCB circuit board, and the Hall sensing device is mounted on a back side of the PCB circuit board.

Further, the Hall sensing device is a Hall chip.

Compared with the prior art, the present application at least has one of the following beneficial effects:
Optimized sound feedback: The bottom end of the key stem contacts and collides with the bottom of the body, which provides focused and clear key feedback sound, and significantly enhances the user experience.

Simplified assembly and maintenance: The magnetic column is inserted from the top end of the key stem and fixed within the mounting groove, which simplifies the assembly process and facilitates subsequent maintenance and replacement. This design not only improves production efficiency but also reduces manufacturing costs.

The beneficial effects listed above do not exhaust all benefits. Other potential beneficial effects and detailed technical embodiments are further disclosed in the embodiments or other descriptions of the present application.

### BRIEF DESCRIPTION OF THE DRAWINGS

Upon reading the following detailed embodiments in conjunction with the drawings, various aspects of the present disclosure are better understood. The positions, dimensions, and ranges of the structures shown in the drawings do not necessarily represent the actual positions, dimensions, or ranges. In the drawings:
FIG. 1 is a schematic diagram of a structure of an embodiment according to the present application.
FIG. 2 is an exploded diagram of a structure of an embodiment according to the present application.
FIG. 3 is a schematic diagram of a cross-sectional structure of an embodiment according to the present application.
FIG. 4 is an exploded diagram of a structure of a key stem in an embodiment according to the present application.

### DETAILED DESCRIPTION OF THE EMBODIMENTS

The present disclosure is described below with reference to the drawings, and the drawings illustrate several embodiments of the present disclosure. It is to be understood, however, that the present disclosure may be embodied in a variety of different ways and is not limited to the embodiments described below. In fact, the embodiments described below are intended to provide a more complete disclosure of the present disclosure and to fully illustrate the scope of the present disclosure to those skilled in the art. It is also to be understood that the embodiments disclosed herein can be combined in various ways to provide additional embodiments.

It is to be understood that, throughout the drawings, like reference numerals refer to like elements. For clarity, certain features in the drawings may be shown with exaggerated or altered dimensions.

It is to be understood that the terminology used in the specification is intended solely to describe particular embodiments and is not meant to limit the present disclosure. All terms (including technical and scientific terms) used in the specification shall have the meanings commonly understood by those skilled in the art unless otherwise defined. For the sake of brevity and/or clarity, well-known techniques, methods, and devices known to those of ordinary skill in the relevant art may not be described in detail but are intended to be part of the specification where appropriate.

Unless clearly indicated otherwise, the singular forms "a", "an" and "the" used in the specification are intended to include the plural forms as well. The terms "comprise", "include", and "including" used in the specification indicate the presence of the stated features, but do not preclude the presence of one or more other features. The term "and/or" used in the specification encompasses any and all possible combinations of one or more of the listed items.

### Embodiment:

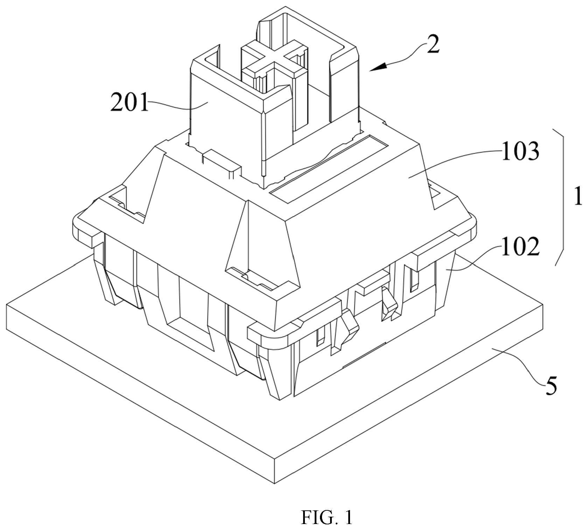

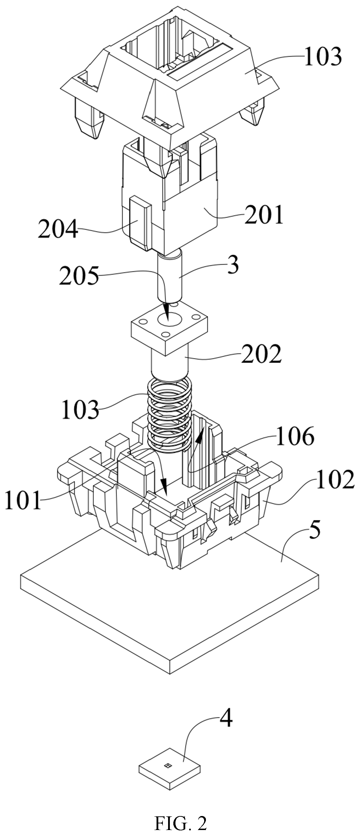

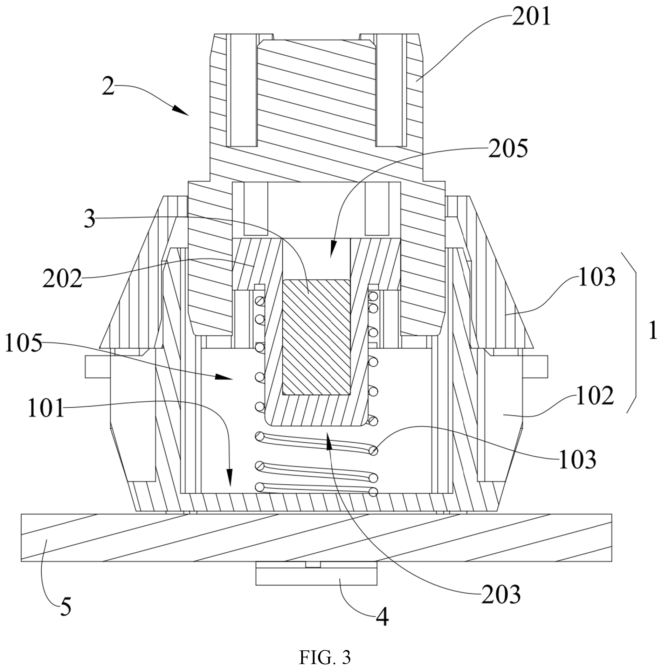

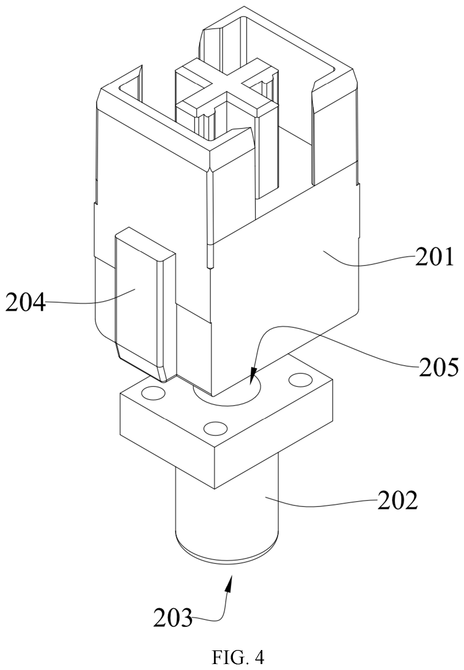

As shown in FIGs. 1 to 4, this embodiment discloses an exemplary structure for achieving the technical objectives of the present application, specifically a central touch-bottom magnetic shaft key.

Structurally, the key includes a body 1 made of a non-magnetic material, a resettable key stem 2 movably mounted within the body 1, a magnetic column 3 arranged within the key stem 2, and a Hall sensing device 4 located on one side of a bottom surface of the body 1 and aligned with the magnetic column 3.

In this embodiment, the body 1 is mounted on a front side of a PCB circuit board 5, the Hall sensing device 4 is mounted on a back side of the PCB circuit board 5, and the Hall sensing device 4 is a Hall chip.

It is to be understood that the Hall sensing device is preferably a Hall chip, which has a small size, high sensitivity, and fast response speed. The Hall chip can monitor the operating status of the key in real time through cooperation with the magnetic column 3, so that the accuracy and reliability of key operations are ensured.

In a specific structure, the key stem 2 of the key includes a main component 201 located at a top and a detachable component 202 located at a bottom, and the main component 201 and the detachable component 202 are axially inserted and connected, where at least the detachable component 202 is a non-magnetic plastic part as an engineering common knowledge.

A sealed solid bottom 203 of the key stem 2 cooperates with a bottom 101 of the body 1, and in a case where the key operates, the sealed solid bottom 203 of the key stem 2 contacts and collides with the bottom 101 of the body 1, thereby providing a key feedback sound.

In this embodiment, the body 1 is composed of a base 102 and a cover 103, and is made of a non-magnetic material, such as ABS plastic or polycarbonate, to avoid magnetic interference. The base 102 and the cover 103 of the body 1 cooperate to form a chamber 105 for receiving and mounting the key stem 2.

More specifically, the body 1 is provided with a vertical linear guide groove 106, and a guide block 204 cooperating with the linear guide groove 106 is laterally protruded on the main component 201 of the key stem 2; and the cooperation between the linear guide groove 106 and the guide block 204 enables guidance during a vertical movement of the key stem 2.

More specifically, in this embodiment, the key stem 2 is connected to the base 102 via at least one elastic element 104, and the key stem 2 resets after moving downward through the elastic element 104.

Preferably, the elastic element 104 is a coil spring. The coil spring has the advantages of a stable elastic force, a long service life, and a good resetting effect. The spring material may be selected from steel or stainless steel to ensure that the key stem 2 maintains good resetting performance during long-term use, thereby prolonging the service life of the key.

More specifically, in this embodiment, the main component 201 of the key stem 2 is connected to the detachable component 202 via a plug-in connection, to ensure stability of the key stem 2 in the vertical direction.

In this embodiment, a mounting groove 205 is provided at a top end of the detachable component 202 facing downward, and a bottom of the mounting groove 205 is positioned near the sealed solid bottom 203 of the key stem 2. The magnetic column 3 is inserted from the top end of the detachable component 202 and fixed in the mounting groove 205, thereby simplifying the mounting process of the magnetic column 3 and ensuring stability of the magnetic column 3 within the key.

More specifically, the material of the detachable component 202 may be selected from POM (polyoxymethylene) or other engineering plastics. These materials have excellent mechanical strength and wear resistance. For example, different plastic materials and hardness may affect the tone and volume during impact, and may be customized according to user preferences. This design not only improves the sound feedback quality of the key, but also increases product personalization and diversity, thereby meeting the requirements of different users.

As an optional technical solution, a plastic impact block (not shown) is provided at a bottom end of the detachable component 202 for controlling the tone, and different plastic materials and designs may be selected to produce different impact sounds, thereby increasing the flexibility of the product.

In this embodiment, the magnetic column preferably uses a high-strength magnetic material, such as a neodymium-iron-boron (NdFeB) magnet, to provide a stable magnetic force. The magnetic column is aligned with the Hall sensing device, and the Hall sensing device detects changes in the position of the magnetic column to achieve precise detection of key operations.

According to the working principle, when a user presses the key, the key stem moves downward along the vertical direction of the body under guidance of the vertical guide groove and the guide block. As the key stem moves downward, the magnetic column moves correspondingly. In a case where the key stem moves downward to a certain position, the bottom end of the key stem collides with the bottom of the body. This collision generates a crisp and pleasant sound feedback, allowing the user to perceive the pressed state of the key audibly. The effect of this sound feedback may be achieved by selecting different plastic materials and designs, thereby meeting the requirements of different users.

Meanwhile, the Hall sensing device 4 detects changes in the position of the magnetic column 3 and generates a corresponding electrical signal, which is transmitted to the PCB circuit board 5 for further processing. The Hall chip can detect displacement of the magnetic column 3 with high sensitivity, thereby ensuring accuracy and reliability of key operations. In a case where the user releases the key, the elastic force of the elastic element 104 causes the key stem 2 to quickly reset, and the key stem 2 and the magnetic column 3 restore to initial positions. The Hall sensing device 4 then detects the change in position of the magnetic column 3, thereby completing the key operation detection process.

Although the exemplary embodiments of the present disclosure have been described, those skilled in the art should understand that various modifications and changes can be made to the exemplary embodiments of the present disclosure without departing from the spirit and scope of the present disclosure. Therefore, all such modifications and changes are encompassed within the scope of the present disclosure as defined by the claims. The present disclosure is defined by the appended claims, and equivalents of these claims are also included.

## Claims

1. A central touch-bottom magnetic shaft key, comprising: a body, a resettable key stem movably mounted within the body, a magnetic column arranged within the key stem, and a Hall sensing device located on one side of a bottom surface of the body and aligned with the magnetic column, wherein a bottom end of the key stem is a sealed solid bottom and cooperates with a bottom of the body, and the bottom end of the key stem contacts and collides with the bottom of the body in a case where the key is operated, so as to provide key feedback sound; the key stem comprises a main component located at a top and a detachable component located at a bottom, and the main component and the detachable component are axially inserted and connected; a lower end of the detachable component is a solid bottom, and an upper end of the detachable component is provided with a mounting groove directed downward, and a bottom of the mounting groove is positioned near a solid bottom end of the key body; and the magnetic column is inserted from a top end of the key body and fixed within the mounting groove.

2. The central touch-bottom magnetic shaft key according to claim 1, wherein a top end of the main component is provided with a clamping position for mounting a keycap.

3. The central touch-bottom magnetic shaft key according to claim 1, wherein a lower section of the detachable component is cylindrical.

4. The central touch-bottom magnetic shaft key according to claim 1, wherein a bottom end of the detachable component is provided with a plastic impact block.

5. The central touch-bottom magnetic shaft key according to claim 1, wherein the body is provided with a vertical linear guide groove, and correspondingly, a guide block cooperating with the linear guide groove is laterally protruded on the main component of the key stem; and the cooperation between the linear guide groove and the guide block enables guidance during a vertical movement of the key stem.

6. The central touch-bottom magnetic shaft key according to claim 1, wherein the body is composed of a base and a cover, the body is hollow to form a chamber for receiving and mounting the key stem, an upper end of the chamber is open, and the key stem extends through the opening.

7. The central touch-bottom magnetic shaft key according to claim 1, wherein the key stem is connected and cooperates with the base via at least one elastic element, and the key stem resets after moving downward through the elastic element.

8. The central touch-bottom magnetic shaft key according to claim 1, wherein the elastic element is a coil spring.

9. The central touch-bottom magnetic shaft key according to claim 1, wherein the body is mounted on a front side of a PCB circuit board, and the Hall sensing device is mounted on a back side of the PCB circuit board.
